# EUROPEAN PATENT APPLICATION

(11) **EP 1 443 338 A1**
(43) Date of publication of application: **04.08.2004**
(21) Application number: 03250662.8
(22) Date of filing: 03.02.2003
(51) Int. Cl.: G01R 31/3185

(54) **Secure test arrangement**

(71) Applicant: STMicroelectronics Limited, Almondsbury, Bristol BS32 4SQ (GB)
(72) Inventor: Ravenhill, Paul, Eastville, Bristol, BS5 6PF (GB); Dellow, Andrew, Minchinhampton, Glos., G16 9JG (GB); Hutson, Matthew, Bristol, BS9 3LY (GB)
(74) Representative: Loveless, Ian Mark

(57) **Abstract**

A port protection circuit, in particular for protecting a JTAG port, comprises logic gates which are switchable to allow the JTAG port to access scan chains or a Diagnostic Control Unit (DCU). The gating arrangement is controlled by a protection circuit that requires a private key to be input through the JTAG port to "unlock" a circuit so that the gating components allow connection between the JTAG port and scan chains or the DCU.

## Description

### FIELD OF THE INVENTION

The invention relates to a semiconductor circuit and to an arrangement for a semiconductor circuit in which security is provided in test components.

### BACKGROUND OF THE INVENTION

In semiconductor circuits so called Design For Test (DFT) arrangements of components are typically used. DFT is a methodology of circuit layout to ensure that a chip can be easily tested for correct operation prior to dispatch to a customer. The most common DFT arrangement is set down in industry standard IEEE standard 1149.1 which was set down in 1985 by a group of manufacturers known as the Joint Test Action Group (JTAG). The standard is now commonly known as JTAG.

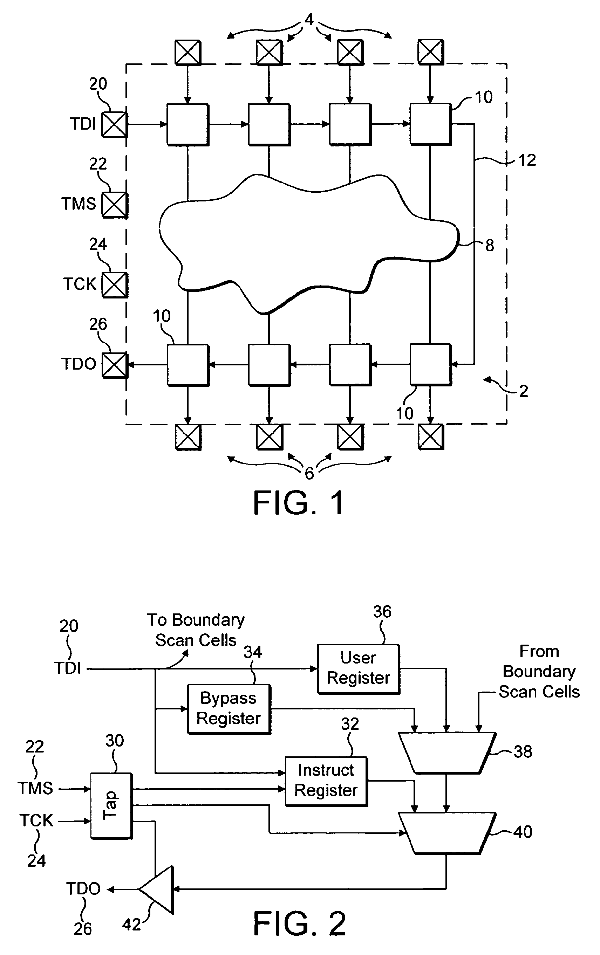

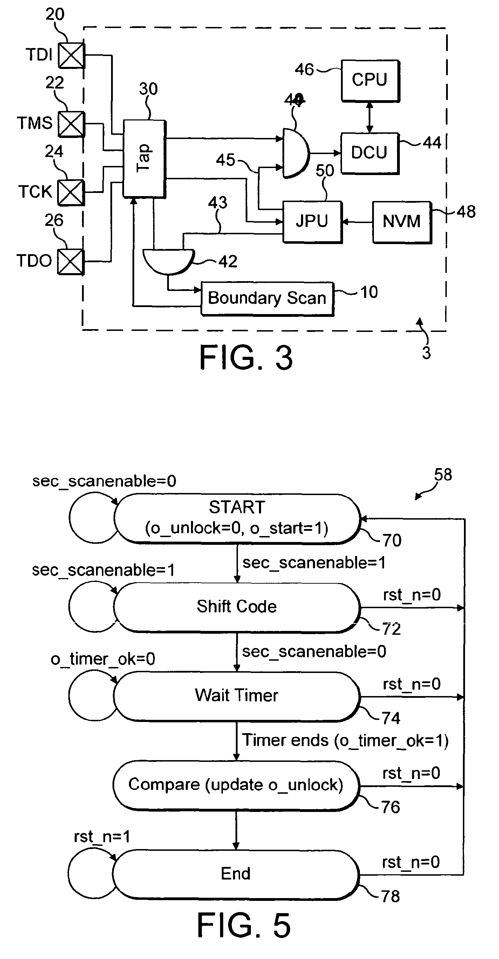

The principles of the JTAG standard and boundary scan arrangements will be described by way of background, with reference to Figures 1 and 2. An example JTAG compatible device 2 is shown in Figure 1 and has four additional pins, two for control and one each for input and output of serial test data. To be compatible, a device must have certain basic test features, but the JTAG standard allows designers to add test features to meet further requirements. The four pins are a test data input (TDI) 20, a test data output (TDO) 26, a test select mode (TMS) 22 and a test clock (TCK) 24. On the device itself, boundary scan testing requires that each input 4 and output 6 has an additional memory element called a boundary scan cell (BSC) 10.

The boundary scan cells 10 are configured as a parallel-in, parallel-out shift register. During normal IC operation, input and output signals pass freely through each BSC 10 from input pins 4 to output pins 6 via logic 8, being the application logic for which the chip 2 is designed. During boundary test mode, however, the chip's boundary is controlled such that data is shifted from TDI pin 20 from one BSC 10 to another around the chain of BSCs linked by line 12 to the TDO pin 26. The test data is clocked by a test clock at TCK pin 24. The test mode select pin TMS 22 accepts control data to set the device 2 either to normal mode or test mode. The device is thereby tested by asserting test mode at TMS pin 22 and clocking test data around the boundary cells 10 from TDI pin 20 to TDO pin 26 under control of TCK 24 clock input. The test pattern of bits on a correctly functioning circuit received at TDO 26 will be the same for any given input for a correctly functioning chip.

The test access port TAP 30 controller is shown in greater detail in Figure 2. TAP 30 is a state machine that inputs TCK 24, TMS 22 and optional TRST signals on the respective pins. The boundary scan architecture also includes an instruction register 32 for holding the current instruction, a one-bit bypass register 34 and an optional 32 bit user ID code register 36. This architecture responds to four mandatory instructions specified in the JTAG standard and six optional or public instructions. The four mandatory instructions are: Extest, Bypass, Sample and Preload.

The Extest instruction causes the boundary scan cells 10 to write to their outputs setting the device to boundary scan mode. The Bypass instruction causes the TDI pin 20 to connect to the bypass register 34 and to the TDO pin 26 via multiplexers 38, 40 thereby bypassing the boundary scan cells. This allows the device to be bypassed where the device is one of a number in a scan chain. The sample instruction executes while the device is in functional mode and not in test mode. The sample instruction selects the boundary-scan register and captures, or samples, incoming values in the boundary scan cells. Lastly, the Preload instruction permits known values to be pre-loaded into the boundary scan cells, such as for initialisation purposes.

As summarised above, and is well known by the skilled person, the JTAG port can thus be used to input data to an integrated circuit for test purposes.

### SUMMARY OF THE INVENTION

We have appreciated, however, that there are conflicting requirements of security and testability in integrated circuits having some security function, such as decrypting data. The JTAG port might allow input of data to such a device causing, for example, the device to overwrite flash memory with unauthorised code.

The invention is defined in the claims to which reference is now directed. An embodiment of the invention includes an additional protection circuit preventing unauthorised access to an integrated circuit via a test or debug port.

### BRIEF DESCRIPTION OF THE FIGURES

An embodiment of the invention will now be described by way of example only and with reference to the accompanying figures in which:
- Figure 1:: is a schematic diagram of an integrated circuit according to the JTAG standard;
- Figure 2:: is a more detailed view of the JTAG port of the circuit of Figure 1;
- Figure 3:: is a schematic diagram showing the main functional blocks of a circuit embodying the invention;
- Figure 4:: is a more detailed view of the circuit embodying the invention; and
- Figure 5:: shows the state machine of Figure 4.

### DESCRIPTION OF A PREFERRED EMBODIMENT

A semiconductor integrated circuit embodying the invention incorporates additional hardware components to protect the device from unauthorised control via a test access or debug port, such as a JTAG port. In the absence of such protection, the CPU of a chip may be accessible to an unauthorised user allowing software to be written to memory altering the functioning of the device. A schematic showing the main functional components of an embodiment is shown in Figure 3.

A circuit 3 includes JTAG pins TDI 20, TMS 22, TCK 24 and TDO 26 as already described which connect to a test access port TAP 30 which is a state machine modified to incorporate the invention. The TAP connects to the boundary scan components here shown as boundary scan 10. the circuit is thereby operable in a boundary scan mode as defined by the JTAG instruction set as previously described. Significantly, however, the circuit includes two gating arrangements 42, 44 to control access to the boundary scan and to the remainder of the circuit.

A first gating arrangement 42, here shown as an AND gate, allows the test access port to connect to the boundary scan chain 10 only if an input on input line 43 is asserted. Similarly, a second gating arrangement 44 only allows the test access port to connect to the diagnostic control unit DCU 44 and consequently to the CPU 46 if an input on input line 45 is asserted. The control of the input lines 43, 45 is from a new component named the JTAG protection unit JPU 50 as will now be described.

The JTAG protection unit JPU 50 comprises a state machine governing access to the boundary scan cells 10 and DCU 44. the DCU 44 is a known diagnostic control unit, which has complete control over the CPU 46, and so has the ability to write to any memory space on the chip. In the embodiment, access to the DCU is restricted by the JPU 50. The JPU 50 itself is accessible by an additional JTAG instruction added to the usual JTAG instruction set received via the test access port 30. the correct instruction must be received by the JPU 50 to cause the JPU to allow access to the DCU 44 and to the boundary scan 10 as already mentioned.

The JPU operation is broadly as follows. A JTAG instruction to access the JPU is received via the TAP 30. the JPU 50 responds by interrogating a non-volatile memory NVM 48, such as an antifuse arrangement, to retrieve a public key. The public key is output at TDO pin 26. To gain access, a response must be given comprising a corresponding private key. If no such response is given access to the boundary scan and DCU is denied by the gating arrangements 42, 44. If a private key is provided in response, this is compared in the JPU with a corresponding private key stored in NVM 48. If the keys match, then the JPU asserts lines 43, 45 allowing the gating arrangements to open. The system is therefore secure in that only an authorised user will have the appropriate private key.

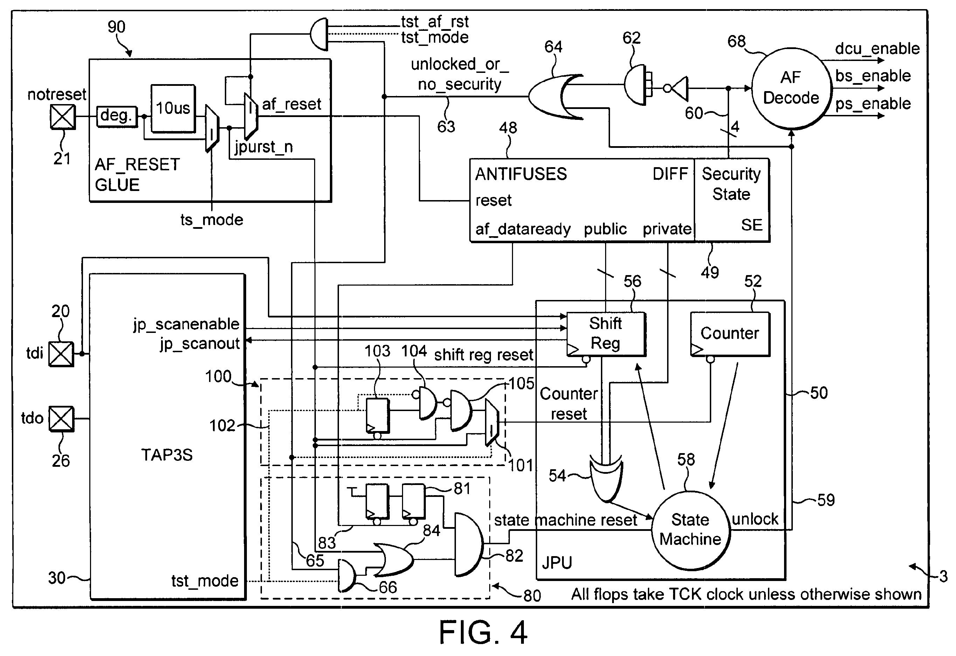

Figure 4 is a more detailed view of a semiconductor circuit 3 embodying the invention. As previously described, the main elements include a test access port TAP 30 shown connected to pins TDI 20 and TDO 26. Although not shown, the TAP 30 also connects to pins TMS and TCK as before. A circuit known as the JTAG protection unit JPU 50 is arranged to control access to a DCU and to boundary or parallel scans depending upon a comparison of a stored private key held in non volatile memory 48, and an input key.

The JPU 50 comprises four blocks: a timer here shown as counter 52, a comparator here shown as XOR tree 54, a shift register 56 and a state machine 58. The security of the JPU is provided by a comparison of stored and received keys in comparator 54. The received key is provided via shift register 56. The shift register 56 is connected between TDI and TDO when the TAP 30 receives the security instruction. On receipt of signal JP-scanout from the TAP 30, the shift register shifts out to TDO pin 26 the public chip ID from antifuses 48. The TAP 30 then asserts signal JP-scanenable that allows serial data to be shifted in to the shift register 56 from TDI 20. The correct private key must be provided at TDI and shifted in to the shift register 56.

The comparator 54 receives the private key provided to the shift register and the private key from antifuses 48 and, if each key matches, a signal is asserted to the state machine 58, indicating that access is allowed.

The unlock state of the JPU is defined by whether the keys match as described above, as governed by the state machine 58. In addition, various preset conditions may be defined in security antifuses 49. The security antifuses determine whether the debug or JTAG port is always accessible, only accessible if the correct key is presented at TDI 20 or never accessible. The antifuse settings are provided on a bus, bus 60 to a gate, AND gate 62, which has an asserted output "1" if the inputs are "1".

The antifuses 49 further define the access to each of DCU, boundary scan BS and parallel scan PS individually.

The comparison of keys and production of an unlock signal to allow access to any one of the DCU, boundary scan or parallel scan is undertaken by the state machine 58, as shown in Figure 5.

The state machine 58 is operable if the antifuses 49 are set such that "Port access and controlled by password exchange". At a first step, step 70, a start state is entered. In this state the output of the state machine is set as locked on line 59 (Figure 4) so that access to the DCU, boundary scan or parallel scan is denied. In this state a signal is set sec_scanenable = 0 preventing the shift register 56 (Figure 4) from shifting. Next at a second step, step 72, the signal is set sec_scanenable = 1 enabling the shift register to shift in the security code input at TDI. At the next step, step 74, a timer operates and this state continues until the timer period ends. At the end of the timer period, at step 76, the comparison of codes in the comparator 54 (Figure 4) is instructed. This state only exists for one clock cycle. If the codes match, then unlock signal on line 59 is asserted, unlock = 1, and the state machine enters an end step and remains in this state until a hard reset is received. If the comparison fails, a chip hard reset is exercised to enable a new code submission to be made.

Referring again to Figure 4, it can be seen that the JPU 50 thus controls locking and unlocking of access to DCU, boundary and parallel scans of the chip. The state machine 58 and shift register 56 together cause a hardware comparison of stored and received codes using comparator 54. We have also appreciated the need to ensure that there are no attacks against this security arrangement. One such attack would be to repeatedly try to input different private keys at TDI for comparison until the correct key is found by chance. To prevent such a "brute force" attack, a long timer pause is provided implemented by counter 52. The user first makes a security access request through a TAP instructions, which causes the chip ID to be read in parallel from antifuse 49. The chip ID is serially read out using shift register 56 using TDO. The corresponding private ID is then provided serially through TDI and read into the shift register 56. At this point, the state machine waits for a timer to expire before comparing the keys.

Other possible attacks have been considered and avoided as follows:

During IC power up, and until a system reset is received, the JPU state machine is held in reset.

Standard DFT practice is to toggle Reset during internal tests. This would reset the JPU, re-locking the IC, therefore to allow continued test coverage after the JPU has been unlocked, the JPU state machine is not reset by system reset if the IC is in test mode and is unlocked.

JPU state machine flip-flops are not on a scan chain to prevent the unlock state being forced in test mode.

To prevent attacks against the "anti-bruteforce" counter, where this counter is loaded with a known value during test mode, and then a comparison made, this counter is reset on leaving test mode. When in test mode, the timer is prevented from expiring.

To provide additional configurability of unlocking procedure, security antifuses 49 are provided as previously described which allow the presetting of how unlock signal on line 59 controls the unlocking precedure defined by antifuse decode unit AF decode 68 (Figure 4).

The 4 bit antifuse 49 defines whether the unlock signal will pass or block:
- a secure dia-scanin for interface with the DCU
- a secure bs_select signal for boundary scan EXTEST
- an enable signal for access to cetain secure scan chains.

This allows various features to be defined as open, locked or keyed.

The relevant mode of diagnostic or scan operation can only be entered if the antifuses are currently set and the correct key provided.

In the embodiment described, the term "key" has been used, though it will be appreciated that any appropriate secret bit sequence, such as an ID or code, would be appropriate to unlock the JPU and these are within the scope of the term "key". Also, the embodiment has been described with reference to the JTAG boundary scan port. Other test or diagnostic ports could be appropriate, and these are within the scope of the invention.

## Claims

1. A semiconductor integrated circuit of the type having a port (30) for debug or testing, comprising a port protection circuit (50) arranged to selectively restrict access to components on the integrated circuit from the port (30), the port protection circuit (50) being arranged to receive a key provided at the port and a key stored on the integrated circuit, to compare the received and stored keys, and to selectively allow access to the components on the integrated circuit for debug or testing depending upon the result of the comparison.

2. A semiconductor integrated circuit according to claim 1, wherein the port protection circuit is arranged to selectively restrict access to scan chains.

3. A semiconductor integrated circuit according to claim 1 or 2, wherein the port protection circuit is arranged to selectively restrict access to a diagnostic control unit.

4. A semiconductor integrated circuit according to any preceding claim, further comprising a gate arrangement coupled to the port protection circuit switchable to selectively connect the port to the components on the integrated circuit.

5. A semiconductor integrated circuit according to any preceding claim, wherein the port protection unit stores a public key and a private key, and wherein the public key is provided at the port in response to an access request and a key input in response to the public key is compared in a comparator to the stored private key.

6. A semiconductor integrated circuit according to any preceding claim, wherein the port protection circuit includes a timer arranged to prevent comparison of received and stored keys more frequently than at a set rate.

7. A semiconductor integrated circuit according to claim 6, wherein the timer is arranged to prevent comparison of received and stored keys until a given time period has expired.

8. A semiconductor integrated circuit according to claim 7, wherein the protection circuit comprises a comparator and the timer controls the comparator such that the given time period must expire before the comparison is performed.

9. A semiconductor integrated circuit according to any preceding claim, wherein the protection circuit is arranged so that it is not reset by resetting the integrated circuit when access to the components is allowed.

10. A semiconductor integrated circuit according to any preceding claim, wherein the components to which access is selectively allowed are scan chains.

11. A semiconductor integrated circuit according to claim 10, wherein the protection circuit does not have any components in scan chains.

12. A semiconductor integrated circuit according to claim 6, 7 or 8, wherein on completion of access to the components, the timer is automatically reset.

13. A semiconductor integrated circuit according to any preceding claim, wherein the port is a JTAG port.

14. A semiconductor integrated circuit according to claim 8, wherein the comparator comprises hardware logic gates.
